# EUROPEAN PATENT SPECIFICATION

(11) **EP 4 509 853 B1**
(45) Date of publication and mention of the grant of the patent: **04.11.2026**
(21) Application number: 23806727.6
(22) Date of filing: 04.05.2023
(51) Int. Cl.: G01R 31/388, B60L 58/14, H02J 7/00

(54) **BATTERY EARLY WARNING METHOD AND APPARATUS, AND VEHICLE AND STORAGE MEDIUM**
BATTERIEFRÜHWARNVERFAHREN UND -VORRICHTUNG SOWIE FAHRZEUG UND SPEICHERMEDIUM
PROCÉDÉ ET APPAREIL D'AVERTISSEMENT PRÉCOCE POUR BATTERIE, VÉHICULE ET SUPPORT DE STOCKAGE

(30) Priority: 16.05.2022 CN 202210529442
(43) Date of publication of application: 19.02.2025
(73) Proprietor: Great Wall Motor Company Limited, Baoding, Hebei 071000 (CN)
(72) Inventor: KANG, Wenrong, Baoding, Hebei 071000 (CN); HE, Jiaxin, Baoding, Hebei 071000 (CN)
(74) Representative: Klunker IP Patentanwälte PartG mbB
(86) International application number: PCT/CN2023/092095
(87) International publication number: WO 2023/221775

(56) References cited:
- WO-A1-2021/142678
- CN-A- 102 830 360
- CN-A- 107 689 655
- CN-A- 108 407 641
- CN-A- 110 194 079
- CN-A- 112 763 920
- CN-A- 114 379 371
- JP-A- 2021 136 762
- JP-A- H07 274 411
- JP-A- H08 185 890
- US-A1- 2002 108 794
- US-A1- 2016 344 208

## Description

### TECHNICAL FIELD

The invention relates to the technical field of batteries, and in particular to a battery early warning method, a corresponding computing and processing device, a vehicle comprising the computing and processing device and a computer-readable storage medium, and corresponding computer program.

### BACKGROUND

At present, batteries are widely used in electric vehicles and energy storage, and due to the particularity, batteries are classified as dangerous goods. Therefore, how to protect the battery is the current technical problem to be solved.

In the prior art, a method for protecting the battery basically uses a battery SOC (State of Charge) to perform determination, and then performs battery early warning protection. In the prior art, when performing fault filtering of a battery SOC being too low, constant-time filtering is often used, and when the battery SOC is lower than a set SOC threshold value, the set time is continued to determine whether the battery SOC is too low.

The inventors of the invention have found that there is still a technical problem in the prior art: whether the battery SOC is too low is only determined according to a constant time, and if the current of other powered devices is large, the same filtering duration is still used, which may lead to excessive actual discharged power, thus seriously damaging the battery. Therefore, how to effectively protect the battery and prevent damage caused by over discharge is the problem that a person skilled in the art needs to solve.

US 2016/344208 A1 discloses a battery managing device including a first calculator, a second calculator, a determiner, and a controller. The first calculator calculates a provisional value indicating a charge state of a battery provided in a vehicle including an electric motor as a drive source. The second calculator calculates the charge state of the battery based on a condition obtained by comparing the provisional value and a boundary point which is on a boundary between a plurality of regions divided in accordance with an available charged amount of the battery. The boundary point is determined based on the available charged amount of the battery in a predetermined degradation state. The determiner determines in which region among the regions the charge state of the battery locates. The controller controls to charge and discharge the battery in accordance with the region determined by the determiner.

### SUMMARY

It is an object of the invention to provide a battery early warning method, a corresponding computing and processing device, a vehicle comprising the computing and processing device, a computer-readable storage medium, and corresponding computer program which overcome or at least partially solve the above-mentioned problems.

The object is achieved by the features of independent claim 1 regarding the method, by the features of independent claim 6 regarding the computing and processing device, by the features of independent claim 7 regarding the vehicle, by the features of independent claim 8 regarding the computer-readable storage medium, by the features of independent claim 9 regarding the computer program. Further embodiments are defined in the dependent claims.

Embodiments of the invention include the following advantages.

With respect to the prior art, the invention does not use a set time to determine the electric quantity state of a battery, but determines whether the battery is over discharged according to the relationship between the accumulated ampere-hour discharge capacity of the battery and a pre-detected reference ampere-hour integral value; using the set time, only the time period during which the battery is discharged can be determined, and the actual total ampere-hour value within the set time cannot be accurately known. In the invention, an accumulated ampere-hour discharge capacity from a moment when the battery discharges to the current moment can be accurately calculated, and then the accumulated ampere-hour discharge capacity is compared with a reference ampere-hour integral value for protecting the battery, so as to determine whether the battery is over discharged, and early warning is provided to the battery in a timely manner, thereby preventing the problem of the over discharge of the battery, preventing the battery from being damaged due to over discharge, and thus effectively protecting the battery.

### BRIEF DESCRIPTION OF THE DRAWINGS

FIG. 1 is a flow chart of steps of a battery early warning method;
FIG. 2 is a flow chart of a step of determining an initial reference ampere-hour integral value;
FIG. 3 is a structural block diagram of a battery early warning apparatus;
FIG. 4 schematically shows a block diagram of a computing and processing device for performing the method; and
FIG. 5 schematically shows a storage unit for holding or carrying a program code implementing the method.

### DETAILED DESCRIPTION

For the purpose, features, and advantages of the invention, which can be more clearly understood, the following will provide further detailed explanations of the invention in conjunction with the accompanying drawings.

In the prior art, determining a SOC of the battery through constant-time filtering cannot effectively prevent the battery from being damaged due to the over discharge of the battery. In order to solve the above-mentioned technical problem, the invention provides a battery early warning method, and the core concept thereof is that: after the state of charge of the battery is lower than a preset state of charge threshold value, an early warning for preventing the over discharge of the battery is provided according to an accumulated ampere-hour discharge capacity value and a reference ampere-hour integral value of the battery.

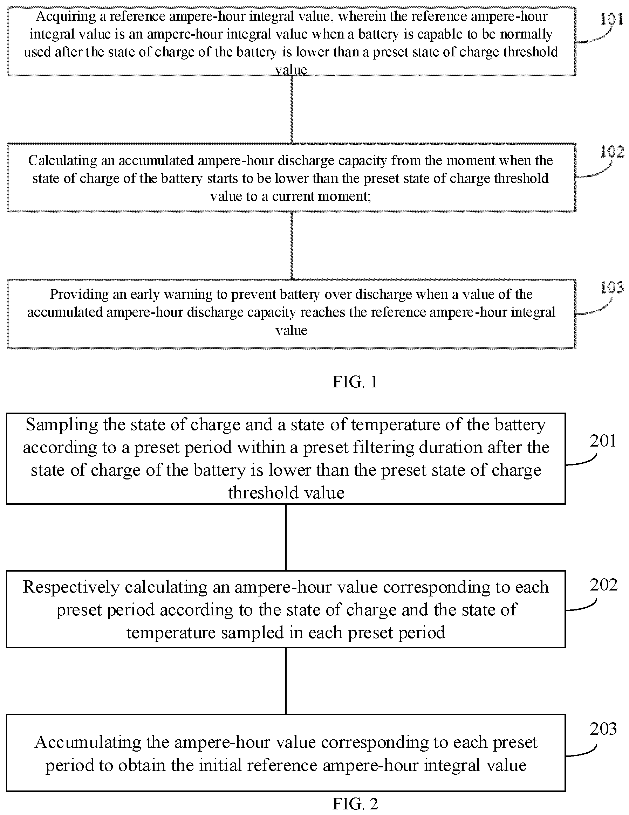

FIG. 1 is a flow chart of steps of a battery early warning method according to the invention, which specifically include the following steps:
Step 101, acquiring a reference ampere-hour integral value, wherein the reference ampere-hour integral value is an ampere-hour integral value when a battery is capable to be normally used after the state of charge of a battery is lower than a preset state of charge threshold value.

When using a vehicle or a battery, a user firstly detects the state of charge of the vehicle or the battery. When the state of charge of the battery reaches a preset state of charge threshold value, a reference ampere-hour integral value when the battery can be normally used after the state of charge of the battery is lower than the preset state of charge threshold value is acquired; and the reference ampere-hour integral value is the amount of electricity which can be normally discharged after the state of charge of the battery is lower than the preset state of charge threshold value, namely, discharging this amount of electricity will not cause over discharge of the battery. The preset state of charge threshold value and the preset filtering duration are set according to the data provided by the battery cell manufacturer. The invention does not define the specific value of the preset state of charge threshold value, for example, it can be 20%, 40%, 60%, 80% or 100%.

In one example, when the state of charge of the vehicle reaches the preset state of charge threshold value, an initial reference ampere-hour integral value and a current state of health of the battery are acquired first, and then the reference ampere-hour integral value is calculated according to the initial reference ampere-hour integral value and the current state of health.

The initial reference ampere-hour integral value of the battery is obtained by pre-detecting relevant parameters of the battery, and then processing and calculating the relevant parameters and relevant data according to the corresponding relationship between the relevant parameters and relevant data provided by the battery cell manufacturer, among them, the initial reference ampere-hour integral value is pre-detected and determined. And when the user uses the vehicle or the battery, the initial reference ampere-hour integral value has been pre-stored in relevant processing device of the vehicle and the battery. When the state of charge of the battery is lower than the preset state of charge threshold value, the reference ampere-hour integral value is determined according to the current state of health and the initial reference ampere-hour integral value of the battery, so as to ensure that the reference ampere-hour integral value is not affected by aging of the battery, wherein the state of health can be a percentage of a current actual capacity of the battery and a capacity of the battery when leaving the factory, and can be expressed as the aging degree of the battery. As the battery is used, the lower the actual capacity of the battery, the higher the degree of aging of the battery, and the lower the state of health of the battery.

The health status of the battery may be periodically detected according to a preset time period, and the health status of the battery may also be detected each time the user uses the vehicle or the battery, and the health status of the battery may also be detected when the state of charge of the battery reaches a preset state of charge threshold value when the user uses the vehicle or the battery, so as to acquire the current health status of the battery, and then the current state of health of the battery is calculated according to the current health status of the battery, and then the reference ampere-hour integral value is calculated using the corresponding relationship between the current state of health of the battery and the initial reference ampere-hour integral value. The health status of the battery may be the current actual capacity of the battery, wherein the state of health of the battery is a percentage of the current actual capacity of the battery to the capacity of the battery when leaving the factory. Generally, the current state of health, the initial reference ampere-hour integral value and the reference ampere-hour integral value are in a multiplication relationship, and the reference ampere-hour integral value is obtained by multiplying the current state of health by the initial reference ampere-hour integral value. The specific relationship of the current state of health, the initial reference ampere-hour integral value, and the reference ampere-hour integral value is not limited herein, and may be set and calculated according to specific situations. Thus, the reference ampere-hour integral value is guaranteed to be the current state, is not affected by the aging of the battery, and avoids affecting the actual reference ampere-hour integral value of the battery due to the aging of the battery.

The initial reference ampere-hour integral value is determined by the following manner:

FIG. 2 is a flow chart of a step of determining an initial reference ampere-hour integral value according to the invention, which is specifically provided as follows:
Step 201, sampling the state of charge and a state of temperature of the battery according to a preset period within a preset filtering duration after the state of charge of the battery is lower than the preset state of charge threshold value.

The initial reference ampere-hour integral value of the battery may be determined when the battery has not left factory or has not been installed on the vehicle, or the initial reference ampere-hour integral value of the battery may be determined after the battery is installed on the vehicle, and the invention is not limited thereto. The initial reference ampere-hour integral value may be different for different battery cell manufacturers of different models.

When the state of charge of the battery is lower than a preset state of charge threshold value, a first-order battery model can be used, and the first-order battery model can be implemented using an equivalent circuit of a single battery and Simscape language, and the state of charge and the state of temperature of the battery within a preset filtering duration are sampled according to a preset period, wherein the preset state of charge threshold value and the preset filtering duration are set according to data provided by a battery cell manufacturer. Data provided by different battery cell manufacturers can have differences; and the preset filtering duration is the duration during which the battery can be normally used after the state of charge of the battery is lower than the preset state of charge threshold value. For example, the preset battery state of charge threshold is 10%, the preset filtering duration is ten minutes, and the preset period is one second. When the state of charge of the battery reaches 10%, the time during which the battery can be normally used is ten minutes, and taking one second as a period, the state of charge and the state of temperature of the battery are sample every one second. The preset period can be determined according to a required finesse. The higher the calculated finesse is, the smaller the time of the preset period is. The time of the preset period is not particularly limited here.

Step 202, respectively calculating an ampere-hour value corresponding to each preset period according to the state of charge and the state of temperature sampled in each preset period.

After sampling the state of charge and the state of temperature of the battery according to the preset period, the state of charge and the state of temperature of each period are obtained, and then an ampere-hour value corresponding to each preset period is respectively calculated according to the state of charge and the state of temperature of each period, among them, the state of charge and the state of temperature of each period may be the same or may be different, and therefore the ampere-hour value corresponding to each preset period may also be the same state or may also be different states. For example, if the preset filtering duration is ten minutes and the preset period is one second, the state of charge and the state of temperature of the battery are sampled every one second, then the sampled state of charge and state of temperature will have six hundred groups of data, and then the ampere-hour values corresponding to the six hundred groups of preset periods are respectively calculated according to the sampled state of charge and state of temperature.

In one example, an internal resistance state of the battery at the current moment and a state of power of the battery at the current moment are determined according to the state of charge and the state of temperature that are sampled. The battery is sampled according to the preset period to obtain the state of charge of the battery at the current moment and the state of temperature of the battery at the current moment, and according to the corresponding relationship among the state of charge at the current moment, the state of temperature at the current moment, and the internal resistance state at the current moment, and the corresponding relationship among the state of charge at the current moment, the state of temperature at the current moment, and the state of power of the battery at the current moment, the internal resistance state of the battery at the current moment and the state of power of the battery at the current moment can be determined. The corresponding relationship among the current state of charge at the current moment, the state of temperature at the current moment, and the internal resistance state at the current moment and the corresponding relationship among the current state of charge at the current moment, the state of temperature at the current moment., and the state of power of the battery at the current moment are provided by the battery cell manufacturer according to batteries of different specifications. For example, the battery cell manufacturer provides the corresponding relationship among the state of charge at the current moment, the state of temperature at the current moment, and the internal resistance state at the current moment as shown in the following table (1), and the corresponding relationship among the state of charge at the current moment, the state of temperature at the current moment, and the state of power of the battery at the current moment as shown in the following table (2):

**Table (1)**

| | 5% | 10% | 15% | 20% |
|---|---|---|---|---|
| 10 °C | 1.115 KΩ | 1.040 KΩ | 0.983 KΩ | 0.966 KΩ |
| 25 °C | 0.639 KΩ | 0.615 KΩ | 0.604 KΩ | 0.575 KΩ |

**Table (2)**

| | 5% | 10% | 15% | 20% |
|---|---|---|---|---|
| 10 °C | 18 KW | 24 KW | 25 KW | 25 KW |
| 25 °C | 23 KW | 46 KW | 54 KW | 62 KW |

If the state of charge of the battery at the current moment is 10%, and the state of temperature of the battery at the current moment is 25 °C, it can be determined according to the corresponding relationship that the internal resistance state of the battery at the current moment is 0.615 KΩ, and the state of power of the battery at the current moment is 46 KW.

A historical open circuit voltage value of an open circuit voltage of the battery at a historical moment corresponding to a previous preset period is determined according to the sampled state of charge. The battery is sampled according to a preset period to obtain a state of charge of the battery, and according to a corresponding relationship between the state of charge of the battery and an open circuit voltage value, the historical open circuit voltage value of the open circuit voltage of the battery at the historical moment corresponding to the previous preset period can be determined, wherein the corresponding relationship between the state of charge of the battery and the open circuit voltage value is provided by a battery cell manufacturer according to batteries of different specifications.

For example, if the preset period is one second, the state of charge and the state of temperature of the battery are sampled every one second; when the sixtieth second is reached, namely, sampling is performed to obtain the state of charge and the state of temperature of the battery at the current moment during the sixtieth preset period, at this moment, the internal resistance state of the battery at the current moment and the state of power of the battery at the current moment are determined by means of the corresponding relationship among the state of charge and the state of temperature of the battery at the current moment during the sixtieth preset period and the internal resistance state at the current moment and the state of power of the battery at the current moment; and by means of the state of charge of the battery sampled in the previous preset period, namely, the sampled fifty-ninth second, that is to say, the sampled state of charge at the fifty-ninth preset period, the open circuit voltage value of the open circuit voltage of the battery during the fifty-ninth preset period, namely, the historical open circuit voltage value of the open circuit voltage of the battery at the historical moment corresponding to the previous preset period, is determined according to the corresponding relationship between the state of charge of the battery and the open circuit voltage value.

The ampere-hour value corresponding to each preset period is respectively calculated according to the state of power of each preset period, the internal resistance state of the preset period, and the historical open circuit voltage value of the open-circuit voltage of the battery at the historical moment corresponding to the previous preset period.

In one example, a current value of the battery at the current moment is determined according to the state of power, the internal resistance state, and the historical open circuit voltage value. After determining the internal resistance state at the current moment of the battery and a state of power of the battery at the current moment and a historical open circuit voltage value of the battery corresponding to the previous preset period according to sampling a state of charge and a state of temperature of the battery, an ampere-hour value corresponding to each preset period is respectively calculated according to the state of power at the current moment of the preset period, the internal resistance state at the current moment and the historical open circuit voltage value of the battery corresponding to the previous preset period. For example, in the current period, it is determined that the state of power at the current moment is Pₜ, the internal resistance state at the current moment is Rₜ, and the historical open circuit voltage value of the battery corresponding to the previous preset period is U_{ocv, t-1}, and in the present embodiment, the current value Iₜ of the battery at the current moment during the current preset period can be calculated through formula (1).${I}_{t} = \frac{{P}_{t}}{{U}_{ocv , t - 1} - {I}_{t} ∗ {R}_{t}}$ Formula (1)

By simplifying Formula (1), Formula (2) can be obtained:
${R}_{t} ∗ {{I}_{t}}^{2} - {U}_{ocv , t - 1} ∗ {I}^{t} + {P}_{t} = 0$ Formula (2)

By solving Formula (2), Formula (3) can be obtained:
${I}_{t} = \frac{{U}_{ocv , t - 1} \pm \sqrt{{U}_{ocv , t - 1}^{2} + 4 ∗ {R}_{t}}}{2 ∗ {R}_{t}}$ Formula (3)

Since the current value of the battery is a positive value, Formula (3) is solved as Formula (4):
${I}_{t} = \frac{{U}_{ocv , t - 1} + \sqrt{{U}_{ocv , t - 1}^{2} + 4 ∗ {R}_{t}}}{2 ∗ {R}_{t}}$ Formula (4)

According to the current value of the battery at the current moment of each preset period, the ampere-hour value corresponding to each preset period is respectively calculated. After the current value of the battery at the current moment during the current period is calculated through the above-mentioned formula (4), the current value of the battery at the current moment in each preset period can be respectively calculated, and then the ampere-hour value corresponding to each preset period can be respectively calculated according to the current value corresponding to each preset period. The ampere-hour value corresponding to the preset period can be calculated through formula (5), wherein T is a time interval of the preset period, and Aht is the ampere-hour value at the current moment. For example, if the preset period is one second, then T in Formula (5) is 1S.${Ah}_{t} = {I}_{t ∗} T$ Formula (5)

Step 203, accumulating the ampere-hour value corresponding to each preset period to obtain the initial reference ampere-hour integral value.

After the ampere-hour value corresponding to each preset period is respectively calculated, the ampere-hour value corresponding to each preset period is accumulated, which can be calculated through Formula (6), and the calculated value is the initial reference ampere-hour integral value, wherein Ahₜₒₗ is the initial reference ampere-hour integral value.
${Ah}_{tol} = \sum {Ah}_{t}$ Formula (6)

Step 102, calculating an accumulated ampere-hour discharge capacity from a moment when the state of charge of the battery starts to be lower than the preset state of charge threshold value to the current moment.

When it is detected that the state of charge of the battery reaches the preset state of charge threshold value, it is started to detect and count the ampere-hour discharge capacity of the battery, and according to the ampere-hour discharge capacity of the battery which is detected and counted, then the accumulated ampere-hour discharge capacity of the battery from the moment when the state of charge starts to be lower than the preset state of charge threshold value to the current moment is calculated. When the state of charge of the battery reaches the preset state of charge threshold value, according to a preset statistical period, the ampere-hour discharge capacity corresponding to each period is respectively counted, and then the ampere-hour discharge capacity corresponding to each period is accumulated to obtain the accumulated ampere-hour discharge capacity of the battery from the moment when the state of charge starts to be lower than the preset state of charge threshold value to the current moment.

Step 103, providing an early warning to prevent an over discharge of the battery when a value of the accumulated ampere-hour discharge capacity reaches the reference ampere-hour integral value.

When it is detected that the accumulated ampere-hour discharge capacity of the battery reaches the acquired reference ampere-hour integral value, the early warning is performed to prevent the battery from being over discharged, among them, the early warning message can be pushed in at least one of the manners including voice, text, short message, etc. When a user borrows a vehicle for a friend to use or the vehicle is not around himself, at this moment, the accumulated discharge capacity of the battery of the vehicle reaches the reference ampere-hour integral value, the user can learn early warning information by means of short message push, and at this moment, the user can prompt the friend in time or charge the battery in time, so as to avoid damage to the battery due to over discharge of the battery, and protect the battery to extend the use time of the battery.

In one example, when the value of the accumulated ampere-hour discharge capacity of the battery reaches the acquired reference ampere-hour integration value, the function consuming the battery without affecting the normal driving may be automatically turned off while the early warning for preventing the over discharge of the battery is performed, thereby reducing the over discharge of the battery and automatically protecting the battery. The functions that do not affect normal driving include an air conditioning function, a player function, a seat heating function, etc. of the vehicle, and the invention is not particularly limited here.

In one example, when the value of the accumulated ampere-hour discharge capacity of the battery reaches the acquired reference ampere-hour integration value, when the early warning is performed to prevent the over discharge of the battery, if the vehicle has a backup battery at this time and the backup battery can be normally used, the battery for powering the vehicle can also be automatically switched to the backup battery at this time, so as to avoid damage to the battery due to the over discharge of the battery, while the battery can be automatically protected. For example, the vehicle carries not only one battery or a group of batteries, but also a backup battery, and the backup battery and the battery being used are present in the same system or the same circuit, when the battery being used by the vehicle for powering is switched to the backup battery, the normal use of the user is not affected. Specifically, at the time of switching, the user does not have the feeling of switching the batteries, and only knows that the batteries have been automatically switched through a switching prompt or a battery use indication, and the user's experience on using the batteries is not affected.

In the above, rather than using a set time to determine the electric quantity state of the battery, whether the battery is over discharged is determined according to the relationship between the accumulated ampere-hour discharge capacity of the battery and the pre-detected reference ampere-hour integral value. The specific discharging ampere-hour value of the battery in each preset period can be accurately known through the accumulated ampere-hour discharge capacity. Using the set time for determination, only the time period during which the battery is discharged can be determined, and the actual total ampere-hour value in the set time cannot be accurately known. Therefore, through the invention, the ampere-hour value with which the battery is discharged and the ampere-hour integral value with which the battery is prevented from over discharge can be accurately and clearly known. Furthermore, the battery is not affected by the aging of the battery, and the battery is early warned in time to prevent the battery from damage due to over discharge, which effectively protects the battery.

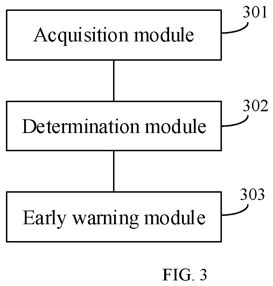

FIG. 3 is a structural block diagram of a battery early warning apparatus as an example how the method of the invention can be implemented, which specifically includes the following modules:
an acquisition module 301 configured for acquiring a reference ampere-hour integral value 301, wherein the reference ampere-hour integral value is an ampere-hour integral value when a battery is capable to be normally used after a state of charge of a battery is lower than a preset state of charge threshold value;
a determination module 302 configured for calculating an accumulated ampere-hour discharge capacity from a moment when the state of charge of the battery starts to be lower than the preset state of charge threshold value to the current moment; and
an early warning module 303 configured for providing an early warning to prevent an over discharge of the battery when the value of the accumulated ampere-hour discharge capacity reaches the reference ampere-hour integral value.

The acquisition module 301 includes:
an acquisition sub-module configured for acquiring an initial reference ampere-hour integral value; and
a first calculation sub-module configured for calculating the reference ampere-hour integral value on the basis of the initial reference ampere-hour integral value and the current state of health.

The apparatus further includes:
a sampling module configured for sampling the state of charge and a state of temperature of the battery according to a preset period within a preset filtering duration after the state of charge of the battery is lower than the preset state of charge threshold value;
a calculation module configured for respectively calculating an ampere-hour value corresponding to each preset period according to the sampled state of charge and the state of temperature in each preset period; and
an accumulation module configured for accumulating the ampere-hour value corresponding to each preset period to obtain the initial reference ampere-hour integral value.

The calculation module may include:
a first determination sub-module configured for determining an internal resistance state of the battery at the current moment and a state of power of the battery at the current moment according to the state of charge and the state of temperature that are sampled;
a second determination sub-module configured for determining a historical open circuit voltage value of an open circuit voltage of the battery at a historical moment corresponding to a previous preset period according to the state of charge that is sampled; and
a second calculation sub-module configured for respectively calculating the ampere-hour value corresponding to each preset period according to the state of power, the internal resistance state and the historical open circuit voltage value of each preset period.

The second calculation sub-module may include:
a determination unit configured for determining a current value of the battery at the current moment according to the state of power, the internal resistance state, and the historical open circuit voltage value; and
calculation unit configured for respectively calculating the ampere-hour value corresponding to each preset period according to the current value of the battery at the current moment of each preset period.

The apparatus may further include:
an automatic shutdown module configured for automatically shutting down a function that consumes the battery without affecting normal driving.

The apparatus may further include:
an automatic switching module configured for automatically switching the battery used to power a vehicle to a backup battery of the vehicle, wherein the backup battery is a battery that can be normally used.

The early warning module may include:
a pushing sub-module configured for, when a value of the accumulated ampere-hour discharge capacity reaches the reference ampere-hour integral value, pushing an early warning message in at least one of the manners including voice, text and short message.

Rather than using a set time to determine the electric quantity state of the battery, whether the battery is over discharged is determined according to the relationship between the accumulated ampere-hour discharge capacity of the battery and the pre-detected reference ampere-hour integral value. The specific discharging ampere-hour value of the battery in each preset period can be accurately known through the accumulated ampere-hour discharge capacity. Using the set time for determination, only the time period during which the battery is discharged can be determined, and the actual total ampere-hour value in the set time cannot be accurately known. Therefore, through the invention, the ampere-hour value with which the battery is discharged and the ampere-hour integral value with which the battery is prevented from over discharge can be accurately and clearly known. Furthermore, the battery is not affected by the aging of the battery, and the battery is early warned in time to prevent the battery from damage due to over discharge, which effectively protects the battery.

For the apparatus, which is substantially similar to the method, the description is relatively simple, with reference to the partial description of the method.

The invention also provides a vehicle, including:
a processor, a memory and a computer program stored on the memory and capable of running on the processor, wherein the computer program, when executed by the processor, implements the various processes of the above-mentioned the battery early warning method and can achieve the same technical effect, and in order to avoid repetition, the description thereof will not be repeated.

The invention further provides a computer-readable storage medium, wherein the computer-readable storage medium stores a computer program, and the computer program, when executed by a processor, implements the various processes of the battery early warning method and can achieve the same technical effect, and in order to avoid repetition, the description thereof will not be repeated.

The methods disclosed herein can be implemented in hardware, software modules running on one or more processors, or a combination thereof. A person skilled in the art should understand that microprocessors or digital signal processors (DSPs) can be used in practice to implement some or all of the functions of some or all components in the computing and processing device according to the invention. The invention can also be implemented as a device or apparatus program (e.g., computer program and computer program product) for performing part or all of the methods described herein. Such a program implementing the invention may be stored on a computer-readable medium or may be in the form of one or more signals. Such signals may be downloaded from an Internet website, provided on a carrier signal, or provided in any other form.

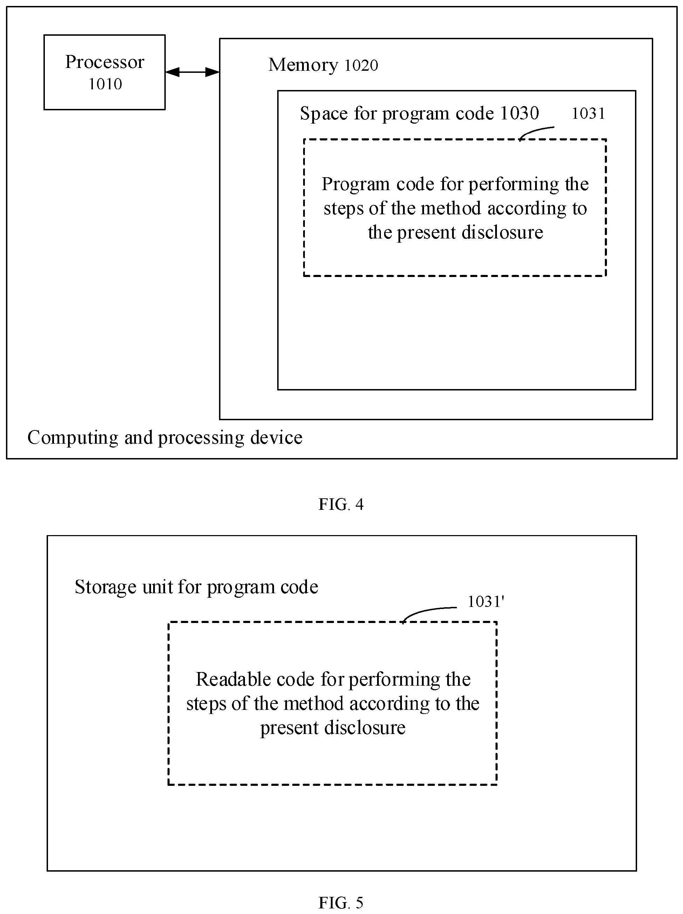

For example, FIG. 4 illustrates a computing and processing device that implements the method in accordance with the invention. The computing and processing device conventionally includes a processor 1010 and a computer program product or a computer-readable medium in the form of a memory 1020. The memory 1020 may be an electronic memory such as flash memory, EEPROM (electrically erasable programmable read only memory), EPROM, hard disk, or ROM, etc. The memory 1020 has a storage space 1030 for program code 1031 for performing any of the method steps described above. For example, the storage space 1030 for the program code may include respective program codes 1031 for implementing the various steps in the above-mentioned method, respectively. The program code may be read from or written to one or more computer program products. These computer program products include a program code carrier such as a hard disk, a compact disc (CD), a memory card or a floppy disk. Such a computer program product is typically a portable or fixed storage unit as described with reference to FIG. 5. The storage unit may have memory segments, storage space, etc. arranged similarly to the memory 1020 in the computing and processing device of FIG. 4. The program code may, for example, be compressed in a suitable form. Typically, the storage unit includes computer-readable code 1031', i.e. code that can be read by a processor, e.g. such as 1010, which, when executed by a computing and processing device, causes the computing and processing device to perform the various steps of the method described above.

The key points of each implementation of the invention are the differences from each other, and the same and similar parts among various embodiments can be referred to each other.

A person skilled in the art will appreciate that the invention may be provided as a method, apparatus, or computer program product. Accordingly, the invention may take the form of an entirely hardware, an entirely software or combining software and hardware aspects. Moreover, the invention can take the form of a computer program product embodied on one or more computer-usable storage media having computer-usable program code embodied therein (including but not limited to disk storage, CD-ROM, optical storage, etc.).

The invention is described with reference to flowchart illustrations and/or block diagrams of methods, terminal devices (systems), and computer program products according to the invention. It will be understood that each flow and/or block of the flowcharts and/or block diagrams, and combinations of flows and/or blocks in the flowcharts and/or block diagrams, can be implemented by computer program instructions. These computer program instructions may be provided to a processor of a general purpose computer, special purpose computer, embedded processor, or other programmable data processing terminal device to produce a machine, such that the instructions, which are executed via the processor of the computer or other programmable data processing terminal device, create means for implementing the functions specified in the flow or flows in the flowchart and/or block or blocks in the block diagram.

These computer program instructions may also be stored in a computer-readable memory that can direct a computer or other programmable data processing terminal device to function in a particular manner, such that the instructions stored in the computer-readable memory produce an article of manufacture including instruction apparatus which implements the function specified in the one process flowchart flow or flows and/or block diagram block or blocks.

These computer program instructions may also be loaded onto a computer or other programmable data processing terminal device to cause a series of operational steps to be performed on the computer or other programmable terminal device to produce a computer implemented process such that the instructions which execute on the computer or other programmable terminal device provide steps for implementing the functions specified in the flow or flows in the flowchart and/or the block or blocks in the block diagram.

Finally, it is noted that relational terms such as first and second, and the like, may be used herein merely to distinguish one entity or action from another entity or action without necessarily requiring or implying any actual such relationship or order between such entities or actions. Furthermore, the terms "include", "comprise", or any other variation thereof, are intended to cover a non-exclusive inclusion, such that a process, method, article, or terminal device that includes a list of elements not only includes those elements but may include other elements not expressly listed or inherent to such process, method, article, or terminal device. An element proceeded by the phrase "comprise a" does not, without more constraints, preclude the existence of additional identical elements in the process, method, article, or terminal device that comprises the element.

## Claims

1. A computer-implemented battery early warning method, comprising:
(S101) acquiring a reference ampere-hour integral value, wherein the reference ampere-hour integral value is an ampere-hour integral value when a battery is capable to be normally used after a state of charge of the battery is lower than a preset state of charge threshold value,
wherein the step of acquiring the reference ampere-hour integral value comprises:
- acquiring an initial reference ampere-hour integral value and a current state of health of the battery; and
- calculating the reference ampere-hour integral value on the basis of the initial reference ampere-hour integral value and the current state of health;
(S102) calculating an accumulated ampere-hour discharge capacity from a moment when the state of charge of the battery starts to be lower than the preset state of charge threshold value to a current moment; and
(S103) providing an early warning to prevent an over discharge of the battery when a value of the accumulated ampere-hour discharge capacity reaches the reference ampere-hour integral value;
**characterized in that**
the initial reference ampere-hour integral value is determined through following steps:
(S201) sampling the state of charge and a state of temperature of the battery according to a preset period within a preset filtering duration after the state of charge of the battery is lower than the preset state of charge threshold value;
(S202) respectively calculating an ampere-hour value corresponding to each preset period according to the state of charge and the state of temperature sampled in each preset period; and
(S203) accumulating the ampere-hour value corresponding to each preset period to obtain the initial reference ampere-hour integral value.

2. The method according to claim 1, wherein the respectively calculating the ampere-hour value corresponding to each preset period according to the state of charge and the state of temperature sampled in each preset period comprises:
determining an internal resistance state of the battery at the current moment and a state of power of the battery at the current moment according to the state of charge and the state of temperature that are sampled;
determining a historical open circuit voltage value of an open circuit voltage of the battery at a historical moment corresponding to a previous preset period according to the state of charge that is sampled; and
respectively calculating the ampere-hour value corresponding to each preset period according to the state of power, the internal resistance state and the historical open circuit voltage value of each preset period.

3. The method according to claim 1, wherein after providing an early warning to prevent the over discharge of the battery when the value of the accumulated ampere-hour discharge capacity reaches the reference ampere-hour integral value, the method further comprises:
automatically shutting down a function that consumes the battery without affecting normal driving.

4. The method according to claim 1, wherein after providing an early warning to prevent the over discharge of the battery when the value of the accumulated ampere-hour discharge capacity reaches the reference ampere-hour integral value, the method further comprises:
automatically switching the battery used to power a vehicle to a backup battery of the vehicle, wherein the backup battery is a battery that can be normally used.

5. The method according to claim 1, wherein the providing an early warning to prevent the over discharge of the battery when the value of the accumulated ampere-hour discharge capacity reaches the reference ampere-hour integral value comprises:
when the value of the accumulated ampere-hour discharge capacity reaches the reference ampere-hour integral value, pushing an early warning message in at least one of manners comprising voice, text and short message.

6. A computing and processing device, comprising:
a memory (1020) in which a computer-readable code (1031) is stored; and
one or more processors (1010), wherein when the computer-readable code (1031) is executed by the one or more processors (1010), the computing and processing device performs the battery early warning method according to any one of claims 1-5.

7. A vehicle, comprising the computing and processing device according to claim 6.

8. A computer-readable storage medium, wherein the computer-readable storage medium stores a computer program thereon, and the computer program, when executed by a processor, causes the processor to implement the steps of the battery early warning method according to any one of claims 1-5.

9. A computer program, comprising a computer-readable code that, when running on a computing and processing device, causes the computing and processing device to perform the battery early warning method according to any one of claims 1-5.

## Patentansprüche

1. Computerimplementiertes Batteriefrühwarnverfahren, aufweisend:
(S101) Erfassen eines Referenz-Amperestunden-Integralwerts, wobei der Referenz-Amperestunden-Integralwert ein Amperestunden-Integralwert ist, wenn eine Batterie normal verwendet werden kann, nachdem ein Ladezustand der Batterie niedriger als ein voreingestellter Ladezustandsschwellenwert ist,
wobei der Schritt des Erfassens des Referenz-Amperestunden-Integralwerts aufweist:
- Erfassen eines anfänglichen Referenz-Amperestunden-Integralwerts und eines aktuellen Gesundheitszustands der Batterie; und
- Berechnen des Referenz-Amperestunden-Integralwerts auf der Grundlage des anfänglichen Referenz-Amperestunden-Integralwerts und des aktuellen Gesundheitszustands;
(S102) Berechnen einer akkumulierten Amperestunden-Entladekapazität von einem Zeitpunkt, zu dem der Ladezustand der Batterie beginnt, niedriger als der voreingestellte Ladezustandsschwellenwert zu sein, bis zu einem aktuellen Zeitpunkt; und
(S103) Bereitstellen einer Frühwarnung, um eine Überentladung der Batterie zu verhindern, wenn ein Wert der akkumulierten Amperestunden-Entladekapazität den Referenz-Amperestunden-Integralwert erreicht;
**dadurch gekennzeichnet, dass**
der anfängliche Referenz-Amperestunden-Integralwert durch folgende Schritte bestimmt wird:
(S201) Abtasten des Ladezustands und eines Temperaturzustands der Batterie gemäß einer voreingestellten Periode innerhalb einer voreingestellten Filterdauer, nachdem der Ladezustand der Batterie niedriger als der voreingestellte Ladezustandsschwellenwert ist;
(S202) jeweiliges Berechnen eines Amperestundenwerts, der jeder voreingestellten Periode entspricht, gemäß dem Ladezustand und dem Temperaturzustand, die in jeder voreingestellten Periode abgetastet werden; und
(S203) Akkumulieren des Amperestundenwerts, der jeder voreingestellten Periode entspricht, um den anfänglichen Referenz-Amperestunden-Integralwert zu erhalten.

2. Verfahren nach Anspruch 1, wobei das jeweilige Berechnen des Amperestundenwerts, der jeder voreingestellten Periode entspricht, gemäß dem Ladezustand und dem Temperaturzustand, die in jeder voreingestellten Periode abgetastet werden, aufweist:
Bestimmen eines Innenwiderstandszustands der Batterie zum aktuellen Zeitpunkt und eines Leistungszustands der Batterie zum aktuellen Zeitpunkt gemäß dem Ladezustand und dem Temperaturzustand, die abgetastet werden;
Bestimmen eines historischen Leerlaufspannungswerts einer Leerlaufspannung der Batterie zu einem historischen Zeitpunkt, der einer vorherigen voreingestellten Periode entspricht, gemäß dem Ladezustand, der abgetastet wird; und
jeweiliges Berechnen des Amperestundenwerts, der jeder voreingestellten Periode entspricht, gemäß dem Leistungszustand, dem Innenwiderstandszustand und dem historischen Leerlaufspannungswert jeder voreingestellten Periode.

3. Verfahren nach Anspruch 1, wobei das Verfahren nach dem Bereitstellen einer Frühwarnung, um die Überentladung der Batterie zu verhindern, wenn der Wert der akkumulierten Amperestunden-Entladekapazität den Referenz-Amperestunden-Integralwert erreicht, ferner aufweist:
automatisches Abschalten einer Funktion, die die Batterie verbraucht, ohne das normale Fahren zu beeinträchtigen.

4. Verfahren nach Anspruch 1, wobei das Verfahren nach dem Bereitstellen einer Frühwarnung, um die Überentladung der Batterie zu verhindern, wenn der Wert der akkumulierten Amperestunden-Entladekapazität den Referenz-Amperestunden-Integralwert erreicht, ferner aufweist:
automatisches Umschalten der Batterie, die zum Versorgen eines Fahrzeugs mit Energie verwendet wird, auf eine Reservebatterie des Fahrzeugs, wobei die Reservebatterie eine Batterie ist, die normal verwendet werden kann.

5. Verfahren nach Anspruch 1, wobei das Bereitstellen einer Frühwarnung, um die Überentladung der Batterie zu verhindern, wenn der Wert der akkumulierten Amperestunden-Entladekapazität den Referenz-Amperestunden-Integralwert erreicht, aufweist:
wenn der Wert der akkumulierten Amperestunden-Entladekapazität den Referenz-Amperestunden-Integralwert erreicht, Pushen einer Frühwarnnachricht auf mindestens eine von Weisen, die Sprache, Text und Kurznachricht aufweisen.

6. Rechen- und Verarbeitungsvorrichtung, aufweisend:
einen Speicher (1020), in dem ein computerlesbarer Code (1031) gespeichert ist; und
einen oder mehrere Prozessoren (1010), wobei, wenn der computerlesbare Code (1031) von dem einen oder den mehreren Prozessoren (1010) ausgeführt wird, die Rechen- und Verarbeitungsvorrichtung das Batteriefrühwarnverfahren nach einem der Ansprüche 1 bis 5 durchführt.

7. Fahrzeug, aufweisend die Rechen- und Verarbeitungsvorrichtung nach Anspruch 6.

8. Computerlesbares Speichermedium, wobei das computerlesbare Speichermedium ein Computerprogramm darauf speichert und das Computerprogramm, wenn es von einem Prozessor ausgeführt wird, den Prozessor veranlasst, die Schritte des Batteriefrühwarnverfahrens nach einem der Ansprüche 1 bis 5 zu implementieren.

9. Computerprogramm, aufweisend einen computerlesbaren Code, der, wenn er auf einer Rechen- und Verarbeitungsvorrichtung läuft, die Rechen- und Verarbeitungsvorrichtung veranlasst, das Batteriefrühwarnverfahren nach einem der Ansprüche 1 bis 5 durchzuführen.

## Revendications

1. Procédé d'avertissement précoce concernant une batterie, mis en œuvre par ordinateur, comprenant les étapes consistant à :
(S101) acquérir une valeur intégrale d'ampères-heures de référence, dans lequel la valeur intégrale d'ampères-heures de référence est une valeur intégrale d'ampères-heures lorsqu'une batterie peut être utilisée normalement après qu'un état de charge de la batterie est devenu inférieur à un état prédéfini de valeur de seuil de charge,
dans lequel l'étape consistant à acquérir la valeur intégrale d'ampères-heures de référence comprend les étapes consistant à :
- acquérir une valeur intégrale d'ampères-heures de référence initiale et un état de santé courant de la batterie ; et
- calculer la valeur intégrale d'ampères-heures de référence sur la base de la valeur intégrale d'ampères-heures de référence initiale et de l'état de santé courant ;
(S102) calculer une capacité de décharge d'ampères-heures cumulée depuis un instant auquel l'état de charge de la batterie commence à être inférieur à l'état prédéfini de valeur de seuil de charge jusqu'à un instant courant ; et
(S103) émettre un avertissement précoce destiné à empêcher une décharge excessive de la batterie lorsqu'une valeur de la capacité de décharge d'ampères-heures cumulée atteint la valeur intégrale d'ampères-heures de référence,
**caractérisé en ce que** :
la valeur intégrale d'ampères-heures de référence initiale est déterminée au moyen des étapes suivantes consistant à :
(S201) échantillonner l'état de charge et un état de température de la batterie en fonction d'une période prédéfinie pendant une durée de filtrage prédéfinie après que l'état de charge de la batterie est devenu inférieur à l'état prédéfini de valeur de seuil de charge ;
(S202) calculer, de façon respective, une valeur d'ampères-heures qui correspond à chaque période prédéfinie en fonction de l'état de charge et de l'état de température qui sont échantillonnés au cours de chaque période prédéfinie ; et
(S203) cumuler les valeurs d'ampères-heures qui correspondent à chaque période prédéfinie afin d'obtenir la valeur intégrale d'ampères-heures de référence initiale.

2. Procédé selon la revendication 1, dans lequel le calcul, de façon respective, de la valeur d'ampères-heures qui correspond à chaque période prédéfinie en fonction de l'état de charge et de l'état de température qui sont échantillonnés au cours de chaque période prédéfinie comprend les étapes consistant à :
déterminer un état de résistance interne de la batterie à l'instant courant et un état de puissance de la batterie à l'instant courant en fonction de l'état de charge et de l'état de température qui sont échantillonnés ;
déterminer une valeur de tension en circuit ouvert historique d'une tension en circuit ouvert de la batterie à un instant historique qui correspond à une période prédéfinie précédente en fonction de l'état de charge qui est échantillonné ; et
calculer, de façon respective, la valeur d'ampères-heures qui correspond à chaque période prédéfinie en fonction de l'état de puissance, de l'état de résistance interne et de la valeur de tension en circuit ouvert historique de chaque période prédéfinie.

3. Procédé selon la revendication 1, dans lequel, après l'émission d'un avertissement précoce destiné à empêcher la décharge excessive de la batterie lorsque la valeur de la capacité de décharge d'ampères-heures cumulée atteint la valeur intégrale d'ampères-heures de référence, le procédé comprend en outre l'étape consistant à :
désactiver automatiquement une fonction qui consomme de l'énergie de la batterie sans affecter la conduite normale.

4. Procédé selon la revendication 1, dans lequel, après l'émission d'un avertissement précoce destiné à empêcher la décharge excessive de la batterie lorsque la valeur de la capacité de décharge d'ampères-heures cumulée atteint la valeur intégrale d'ampères-heures de référence, le procédé comprend en outre l'étape consistant à :
commuter automatiquement la batterie utilisée pour alimenter un véhicule sur une batterie de secours du véhicule,
dans lequel la batterie de secours est une batterie qui peut être utilisée normalement.

5. Procédé selon la revendication 1, dans lequel l'étape consistant à émettre un avertissement précoce destiné à empêcher la décharge excessive de la batterie lorsque la valeur de la capacité de décharge d'ampères-heures cumulée atteint la valeur intégrale d'ampères-heures de référence comprend :
lorsque la valeur de la capacité de décharge d'ampères-heures cumulée atteint la valeur intégrale d'ampères-heures de référence, la délivrance d'un message d'avertissement précoce selon au moins l'un de modes de délivrance comprenant un message vocal, un message textuel et un message court.

6. Dispositif informatique et de traitement, comprenant :
une mémoire (1020) dans laquelle un code lisible par ordinateur (1031) est stocké ; et
un ou plusieurs processeurs (1010),
dans lequel, lorsque le code lisible par ordinateur (1031) est exécuté par les un ou plusieurs processeurs (1010), le dispositif informatique et de traitement met en œuvre le procédé d'avertissement précoce concernant une batterie selon l'une quelconque des revendications 1 à 5.

7. Véhicule, comprenant le dispositif informatique et de traitement selon la revendication 6.

8. Support de stockage lisible par ordinateur, dans lequel le support de stockage lisible par ordinateur stocke en son sein un programme informatique, et le programme informatique, lorsqu'il est exécuté par un processeur, force le processeur à mettre en œuvre les étapes du procédé d'avertissement précoce concernant une batterie selon l'une quelconque des revendications 1 à 5.

9. Programme informatique, comprenant un code lisible par ordinateur qui, lorsqu'il est exécuté sur un dispositif informatique et de traitement, force le dispositif informatique et de traitement à mettre en œuvre le procédé d'avertissement précoce concernant une batterie selon l'une quelconque des revendications 1 à 5.
